# EUROPEAN PATENT APPLICATION

(11) **EP 4 845 356 A1**
(43) Date of publication of application: **25.11.2026**
(21) Application number: 25867501.6
(22) Date of filing: 19.05.2025
(51) Int. Cl.: H10F 77/20

(54) **BACK CONTACT CELL, CELL MODULE AND PHOTOVOLTAIC SYSTEM**

(30) Priority: 20.09.2024 CN 202411330365
(71) Applicant: Zhejiang Aiko Solar Technology Co., Ltd, Jinhua, Zhejiang 322000 (CN)
(72) Inventor: QIU, Kaifu, Jinhua, Zhejiang 322000 (CN); YANG, Xinqiang, Jinhua, Zhejiang 322000 (CN); WANG, Yongqian, Jinhua, Zhejiang 322000 (CN); CHEN, Gang, Jinhua, Zhejiang 322000 (CN)
(74) Representative: EP&C
(86) International application number: PCT/CN2025/095789
(87) International publication number: WO 2026/060978

(57) **Abstract**

The present disclosure relates to the field of solar cell technology, and provides a back contact cell, a cell assembly, and a photovoltaic system. A back surface of a silicon substrate of the back contact cell has a plurality of polished regions and a plurality of textured regions. A first passivation layer and a first polar doped layer are sequentially stacked on the polished region, while a second passivation layer and a second polar doped layer are sequentially stacked on the textured region and cover at least the textured region. First transparent conductive films are arranged on the first polar doped layer, and second transparent conductive films are arranged on the second polar layer. A thickness of a portion of the second transparent conductive films corresponding to the textured region is less than a thickness of the first transparent conductive films. Accordingly, by setting the thickness of the portion of the second transparent conductive films located on the textured region to be small, parasitic absorption at the textured region can be reduced when light enters from the back surface, thereby enhancing the bifaciality of the back contact cell. Meanwhile, configuring part of a region of the back surface as a textured surface can further reduce the reflectivity of light on the back surface, thereby further improving the bifaciality.

## Description

### Cross-Reference to Related Application

The present disclosure claims priority to Chinese Patent Application No. 202411330365.0, filed with the China National Intellectual Property Administration on September 20, 2024, and entitled "BACK CONTACT CELL, CELL ASSEMBLY, AND PHOTOVOLTAIC SYSTEM", which is incorporated herein by reference in its entirety.

### Technical Field

The present disclosure relates to the field of solar cell technology, and in particular, to a back contact cell, a cell assembly, and a photovoltaic system.

### Background

Currently, among solar cells, a hybrid back contact cell is a type of cell where both emitter and base contact electrodes are placed on a back surface (non-light-receiving surface) of the cell. With no metal electrodes obstructing the light-receiving surface of the cell, the short-circuit current of a cell piece is effectively increased.

To enhance the efficiency of the back contact cell, one of doped layers in the back contact cell can be set as a polysilicon layer, while the other doped layer can be configured as a different type of doped layer, such as an amorphous silicon layer or microcrystalline silicon layer. Subsequently, a transparent conductive oxide (TCO) film or other transparent conductive films are applied, thereby forming the hybrid back contact cell, which is also known as a hybrid back contact (HBC) technology. However, the bifaciality of the hybrid back contact cell in the related art remains low. Therefore, how to improve the bifaciality of the hybrid back contact cell has become a technical problem under researches by technicians.

### Summary

The present disclosure provides a back contact cell, a cell assembly, and a photovoltaic system.

The present disclosure is implemented in this manner. The back contact cell in this embodiment of the present disclosure includes:
a silicon substrate, having a front surface and a back surface which are opposite, where the back surface includes a plurality of polished regions and a plurality of textured regions which are alternately arranged in a first direction and all extend in a second direction, and the second direction intersects with the first direction;
a first passivation contact structures, wherein each of the first passivation contact structures include a first passivation layer and a first polar doped layer which are sequentially stacked on the polished region;
a second passivation contact structures, wherein each of the second passivation contact structures include a second passivation layer and a second polar doped layer sequentially stacked on the textured region, where the second passivation layer and the second polar doped layer cover at least the textured region; and
a first transparent conductive film and a second transparent conductive films, where the first transparent conductive films are stacked on the first polar doped layer and covers at least part of a region of the first polar doped layer, while the second transparent conductive films are stacked on the second polar doped layer and covers at least part of a region of a portion of the second polar doped layer corresponding to the textured region, the second transparent conductive films are insulated and spaced apart from the first transparent conductive films, and a thickness of the portion of the second transparent conductive films corresponding to the textured region is less than a thickness of the first transparent conductive films.

In some embodiments, the first passivation layer is a tunneling oxide layer, and the first polar doped layer is a doped polysilicon layer; and
the second passivation layer is at least one of an intrinsic amorphous silicon layer or a tunneling oxide layer, while the second polar doped layer is at least one of a doped amorphous silicon layer or a doped microcrystalline silicon layer.

In some embodiments, the thickness of the portion of the second transparent conductive film corresponding to the textured region ranges from 75 nm to 85 nm.

In some embodiments, the thickness of the first transparent conductive film ranges from 90 nm to 155 nm.

In some embodiments, a ratio of the thickness of the first transparent conductive film to the thickness of the portion of the second transparent conductive film corresponding to the textured region ranges from 1.2 to 1.8.

In some embodiments, the first polar doped layer and the second polar doped layer are adjacent in the first direction; or, the first polar doped layer and the second polar doped layer are spaced apart in the first direction.

In some embodiments, the first transparent conductive film is stacked solely on the first polar doped layer, the second passivation layer and the second polar doped layer are stacked solely on the textured region, and the second transparent conductive film is stacked solely on the second polar doped layer.

In some embodiments, the first polar doped layer is a base doped layer, while the second polar doped layer is an emitter doped layer, and a total orthographic projection area of all the second polar doped layers on the silicon substrate is greater than that of all the first polar doped layers on the silicon substrate.

In some embodiments, a ratio of the total orthographic projection area of all the second polar doped layers on the silicon substrate to an area of the back surface ranges from 65% to 85%
In some embodiments, at preset positions of at least some of the second passivation contact structures, the second passivation layer has a passivation extension that extends to cover part of the region of the first polar doped layer. The second polar doped layer has a doping extension that extends to cover the passivation extension, thereby forming a stacked structure on a portion of the polished region, where the first passivation layer, the first polar doped layer, the passivation extension, and the doping extension are sequentially stacked.

The second transparent conductive film has a film extension that extends onto at least a part of a region of the doping extension, while the first transparent conductive film is stacked at least on a region of the first polar doped layer not covered by the passivation extension and the doping extension.

In some embodiments, a thickness of the film extension is greater than the thickness of the portion of the second transparent conductive film corresponding to the textured region.

In some embodiments, the thickness of the film extension is the same as that of the first transparent conductive film.

The present disclosure further provides a cell assembly, including a plurality of back contact cells according to any one of the foregoing items.

The present disclosure further provides a photovoltaic system, including the foregoing cell assembly.

In the back contact cell, the cell assembly, and the photovoltaic system in the embodiments of the present disclosure, the back surface of the silicon substrate has the plurality of polished regions and the plurality of textured regions. The first passivation layer and the first polar doped layer are sequentially stacked on the polished region, while the second passivation layer and the second polar doped layer are sequentially stacked on the textured region and cover at least the textured region. The first transparent conductive film is arranged on the first polar doped layer, and the second transparent conductive film is arranged on the second polar layer, with the two being insulated and spaced apart. The thickness of the portion of the second transparent conductive film corresponding to the textured region is less than the thickness of the first transparent conductive film. Accordingly, by setting the thickness of the portion of the second transparent conductive film located on the textured region to be small, parasitic absorption at the textured region can be reduced when light enters from the back surface, thereby enhancing the bifaciality of the back contact cell. Meanwhile, configuring part of a region of the back surface as a textured surface can further reduce the reflectivity of light on the back surface, thereby further improving the bifaciality.

Additional aspects and advantages of the present disclosure will be partially given in the following description, with some becoming apparent from the following description or discernible from practices of the present disclosure.

### Brief Description of the Drawings

Fig. 1 is a modular schematic diagram of a photovoltaic system according to an embodiment of the present disclosure;
Fig. 2 is a modular schematic diagram of a cell assembly according to an embodiment of the present disclosure;
Fig. 3 is a cross-sectional schematic diagram of a back contact cell according to an embodiment of the present disclosure;
Fig. 4 is another cross-sectional schematic diagram of a back contact cell according to an embodiment of the present disclosure;
Fig. 5 is a schematic diagram of a plane structure of a back contact cell according to an embodiment of the present disclosure; and
Fig. 6 is yet another cross-sectional schematic diagram of a back contact cell according to an embodiment of the present disclosure.

### Descriptions of main component numerals:

1000-photovoltaic system; 200-cell assembly; 100-back contact cell; 10-silicon substrate; 11-front surface; 12-back surface; 121-polished region; 122-textured region; 20-first passivation contact structure; 21-first passivation layer; 22-first polar doped layer; 30-second passivation contact structure; 31-second passivation layer; 32-second polar doped layer; 320-preset position; 321-doping extension; 40-first transparent conductive film; and 50-second transparent conductive film.

### Detailed Description of the Embodiments

In order to provide a clearer understanding of the objectives, technical solutions, and advantages of the present disclosure, the present disclosure is further described in detail in conjunction with accompanying drawings and embodiments below. Examples of the embodiments are shown in accompanying drawings, where the same or similar elements or the elements having the same or similar functions are denoted by the same or similar reference numerals throughout the description. The embodiments described below with reference to the accompanying drawings are exemplary, are used only for explaining the present disclosure, and should not be construed as a limitation on the present disclosure. Additionally, it should be understood that the specific embodiments described herein are merely used for explaining the present disclosure rather than limiting the present disclosure.

In the description of the present disclosure, it should be understood that orientation or positional relationships indicated by the terms such as "length", "width", "upper", "lower", "transverse", and "longitudinal", are based on orientation or positional relationships shown in the accompanying drawings, and are intended to facilitate the description of the present disclosure and simplify the description only, rather than indicate or imply that an apparatus or element referred needs to have a particular orientation or be constructed and operated in a particular orientation. Therefore, such terms should not be construed as limiting the present disclosure.

In addition, the terms "first" and "second" are used merely for the purpose of description, and shall not be construed as indicating or implying relative importance or implying a quantity of indicated technical features. Therefore, features defined with "first" and "second" may explicitly or implicitly include one or more of the features. In the descriptions of the present disclosure, unless otherwise explicitly limited, "a plurality of" means two or more than two.

In the description of the present disclosure, it should be noted that the terms "mounted", "connected", and "linked" should be understood in a broad sense, unless otherwise explicitly specified and limited. For example, it may be a fixed connection, a detachable connection, or an integrated connection; it may be a mechanical connection, an electrical connection, or a mutual communication; or it may be a direct connection, an indirect connection through an intermediate medium, a communication between interiors of two elements, or an interaction relationship between the two elements. Those of ordinary skill in the art may understand the specific meanings of the foregoing terms in the present disclosure according to specific situations.

In the present disclosure, unless otherwise expressly specified and limited, a first feature being "above" or "below" a second feature may include direct contact between the first feature and the second feature, or may also include indirect contact between the first feature and the second feature through an additional feature therebetween. In addition, the first feature being "over", "above", and "on" the second feature includes the first feature being over and above the second feature, or merely indicates that a level of the first feature is higher than that of the second feature. The first feature being "under", "below", and "underneath" the second feature includes the first feature being under and below the second feature, or merely indicates that the level of the first feature is lower than that of the second feature.

The following disclosure provides multiple different embodiments or examples to implement different structures of the present disclosure. To simplify the disclosure of the present disclosure, components and settings in particular examples are described below. Certainly, they are merely examples and are not intended to limit the present disclosure. Further, in the present disclosure, at least one of reference numerals and reference letters may be repeated in different examples, and such repetition is for simplification and clarity purposes and does not indicate a relationship between at least one of the various embodiments and/or settings being discussed. In addition, the present disclosure provides examples of various specific processes and materials, but those of ordinary skill in the art can realize the application of other processes and scenarios involving the use of at least one of other materials.

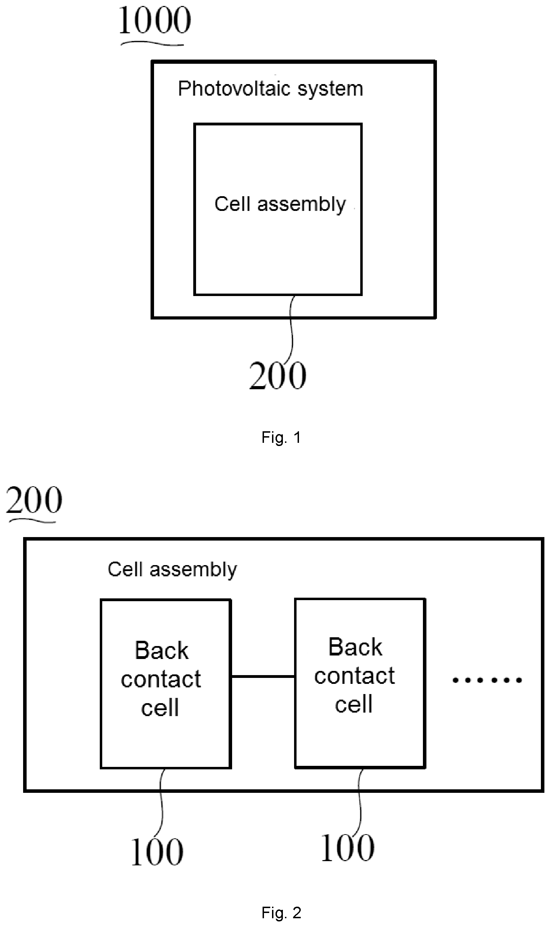

Referring to Fig. 1 and Fig. 2, a photovoltaic system 1000 in this embodiment of the present disclosure may include a cell assembly 200 in this embodiment of the present disclosure. The cell assembly 200 in this embodiment of the present disclosure may include a plurality of back contact cells 100 in this embodiment of the present disclosure.

In this embodiment of the present disclosure, the plurality of back contact cells 100 in the cell assembly 200 may be connected in series to form a plurality of cell strings. A method for achieving current collection and output from each cell string may include one of the following: series connection, parallel connection, or a series-parallel combination. For example, connections between cell pieces may be achieved by welding soldering ribbons, and connections between the cell strings may be achieved through busbars. In some embodiments, the cell strings may form a cell piece array, which is then encapsulated together with a front sheet, a front adhesive film, a rear adhesive film, and a back sheet to form the cell assembly 200.

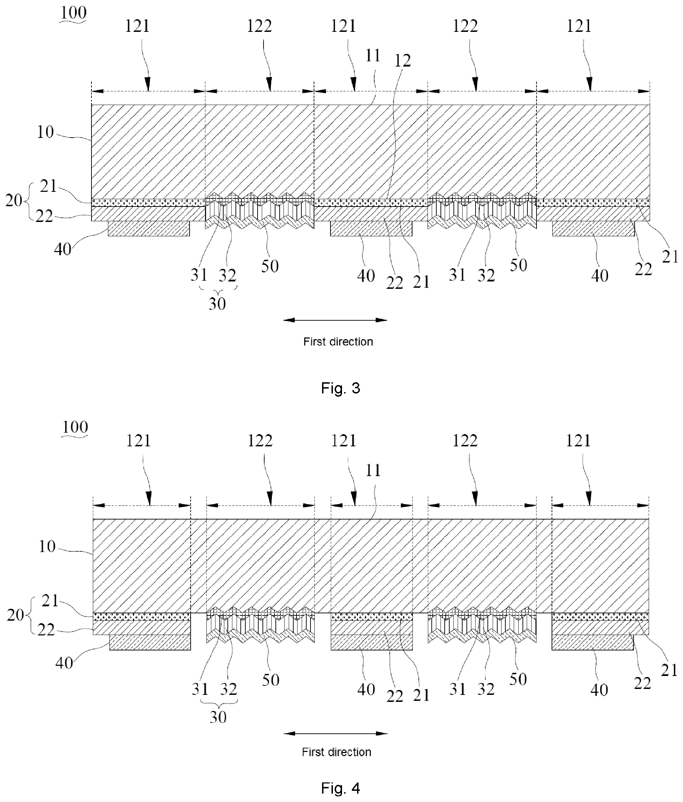

Referring to Fig. 3, the back contact cell 100 in this embodiment of the present disclosure may include a silicon substrate 10, first passivation contact structures 20, second passivation contact structures 30, first transparent conductive films 40, and second transparent conductive films 50.

The silicon substrate 10 has a front surface 11 and a back surface 12 opposite to each other. The back surface 12 includes a plurality of polished regions 121 and a plurality of textured regions 122. The plurality of polished regions 121 and the plurality of textured regions 122 are alternately arranged in a first direction and all extend in a second direction, and the second direction intersects with the first direction.

Specifically, as shown in Fig. 3, the polished regions 121 and the textured regions 122 may be alternately arranged in a transverse direction of the silicon substrate 10 and both extend in a longitudinal direction. That is, the first direction may be a transverse direction of the back contact cell 100, and the second direction may be the transverse direction of the back contact cell 100, with the two being perpendicular to each other. Of course, in other embodiments, the first direction and the second direction may also be other directions, which, for example, may be diagonal directions of the silicon substrate 10 respectively, and specific limitations are not imposed herein.

The first passivation contact structure 20 may include a first passivation layer 21 and a first polar doped layer 22 sequentially stacked on the polished region 121 (each polished region 121 is provided with the first passivation contact structure 20, with a one-to-one correspondence between their quantities). That is, the first passivation layer 21 is stacked on the polished region 121, and the first polar doped layer 22 is stacked on the first passivation layer 21.

The second passivation contact structure 30 may include a second passivation layer 31 and a second polar doped layer 32 sequentially stacked on the textured region 122 (each textured region 122 is provided with the second passivation contact structure 30, with a one-to-one correspondence between their quantities). The second passivation layer 31 and the second polar doped layer 32 cover at least the textured region 122.

Exemplarily, in some embodiments, the first polar doped layer 22 only covers the polished region 121 in a stacked manner, while the second polar doped layer 32 covers at least part of the textured region 122. A surface of a portion of the second polar doped layer 32 that corresponds to the textured region 122 and faces away from the silicon substrate 10, may be textured. That is, in the second passivation contact structure 30, the second passivation layer 31 is arranged on the textured region 122, and the second polar doped layer 32 is stacked on the second passivation layer 31. A back surface of the portion of the second polar doped layer 32 corresponding to the textured region 122 may be textured.

As shown in Fig. 3, the first transparent conductive film 40 is stacked on the first polar doped layer 22 and covers at least part of a region of the first polar doped layer 22, while the second transparent conductive film 50 is stacked on the second polar doped layer 32 and covers at least part of a region of the portion of the second polar doped layer 32 corresponding to the textured region 122. The second transparent conductive film 50 is insulated and spaced apart from the first transparent conductive film 40.

A thickness of the portion of the second transparent conductive film 50 corresponding to the textured region 122 is less than a thickness of the first transparent conductive film 40. That is, the thickness of the portion of the second transparent conductive film 50 located on the textured region 122 is less than the thickness of the first transparent conductive film 40.

It should be noted that, in this context, when a film layer covers or is stacked to cover part or all of an area of a surface or another film layer, the film layer may be directly stacked on the surface or the another film layer, or other film layers may also be arranged between the film layer and the surface or the another film layer. "Cover" is merely used to define a specific setting range of the film layer.

Additionally, in this context, a portion of a film layer corresponding to a certain region or a certain layer structure refers to a portion of the film layer that overlaps with the region or another layer structure in the thickness direction. For example, the portion of the second transparent conductive film 50 corresponding to the textured region 122 refers to a region of the second transparent conductive film 50 covering the textured region 122. If similar descriptions appear below, reference may be made to this place for understanding.

In the back contact cell 100, the cell assembly 200, and the photovoltaic system 1000 in the embodiments of the present disclosure, the back surface 12 of the silicon substrate 10 has the plurality of polished regions 121 and the plurality of textured regions 122. The first passivation layer 21 and the first polar doped layer 22 are sequentially stacked on the polished region 121, while the second passivation layer 31 and the second polar doped layer 32 are sequentially stacked on the textured region 122 and cover at least the textured region 122. The first transparent conductive film 40 is arranged on the first polar doped layer 22, and the second transparent conductive film 50 is arranged on the second polar layer 32, with the two being insulated and spaced apart. The thickness of the portion of the second transparent conductive film 50 corresponding to the textured region 122 is less than the thickness of the first transparent conductive film 40. Accordingly, by setting the thickness of the portion of the second transparent conductive film 50 located on the textured region 122 to be small, parasitic absorption at the textured region 122 can be reduced when light enters from the back surface 12, thereby enhancing the bifaciality of the back contact cell 100. Meanwhile, configuring part of a region of the back surface 12 as a textured surface can further reduce the reflectivity of light on the back surface 12, thereby further improving the bifaciality.

In other words, in the present disclosure, part of the region of the back surface 12 is configured as the textured region 122, and the thickness of the portion of the second transparent conductive film 50 corresponding to the textured region 122 is set to be small. Through such optimized design, the bifaciality of the back contact cell 100 can be improved.

Specifically, in this embodiment of the present disclosure, the silicon substrate 10 may be either an N-type silicon substrate or a P-type silicon substrate, which is not specifically limited herein. The first polar doped layer 22 may be an N-type doped layer, and the second polar doped layer 32 may be a P-type doped layer, or, the first polar doped layer 22 may be a P-type doped layer, and the second polar doped layer 32 may be an P-type doped layer, with no specific limitations imposed herein as long as their polarities are opposite. Additionally, in the back contact cell of the present disclosure, a first electrode (not shown in the figures) may also be arranged on the first transparent conductive film 40, and a second electrode (not shown in the figures) may also be arranged on the first transparent conductive film 40. Current collection, convergence, and output can be achieved through the first electrode and the second electrode.

Both the first transparent conductive film 40 and the second transparent conductive film 50 may be film layers that combine light transmittance and conductivity, such as TCO film layers, each of which may be a single film layer or a multilayer composite film layer, with no specific limitations imposed herein.

In the present disclosure, the back contact cell 100 may be a hybrid back contact cell. The first passivation layer 21 may be a tunneling oxide layer, such as a tunneling silicon oxide layer, and the first polar doped layer 22 may be a doped polysilicon layer. The second passivation layer 31 may be at least one of an intrinsic amorphous silicon layer or a tunneling oxide layer (e.g., a tunneling silicon oxide layer), while the second polar doped layer 32 may be at least one of a doped amorphous silicon layer or a doped microcrystalline silicon layer.

In this case, the first passivation contact structure 20 is a tunneling passivation contact structure, and the second passivation contact structure 30 is a hetero junction passivation contact structure. Accordingly, by designing the first polar doped layer 22 as the doped polysilicon layer and the second polar doped layer 32 as at least one of the doped amorphous silicon layer or the doped microcrystalline silicon layer, the hybrid back contact cell 100 can be formed, thereby improving the efficiency of the back contact cell 100.

Meanwhile, configuring the region corresponding to the doped polysilicon as the polished region 121 can prevent a significant reduction in passivation effect in the region corresponding to the doped polysilicon, and thus avoid affect efficiency. The passivation effect of at least one of the doped amorphous silicon or the doped microcrystalline silicon is superior, and configuring the region corresponding to the doped amorphous silicon or the doped microcrystalline silicon as the textured surface can enhance an anti-reflection effect on the back surface 12, thereby improving the bifaciality of the back contact cell 100. In other words, in this case, the bifaciality of the back contact cell 100 can be further improved while ensuring the passivation effect in the region corresponding to the first polar doped layer 22.

In some embodiments, the first polar doped layer 22 may be a P-type doped polysilicon layer, and the second polar doped layer 32 may be at least one of an N-type doped amorphous silicon layer or an N-type doped microcrystalline silicon layer. Certainly, in other embodiments, the first polar doped layer 22 may be an N-type doped polysilicon layer, and the second polar doped layer 32 may be at least one of a P-type doped amorphous silicon layer or a P-type doped microcrystalline silicon layer, with no specific limitations imposed herein.

In some embodiments, the thickness of the portion of the second transparent conductive film 50 corresponding to the textured region 122 may range from 75 nm to 85 nm.

Therefore, setting the thickness of the portion of the second transparent conductive film 50 corresponding to the textured region 122 within the reasonable range can avoid excessive manufacturing difficulty due to an overly small thickness of the portion of the second transparent conductive film 50 corresponding to the textured region 122, as well as a poor passivation effect on the second polar doped layer 32 caused by the overly small thickness. Additionally, excessive cost increases due to an overly large thickness can also be avoided. In other words, setting the thickness within the foregoing reasonable range can reduce parasitic absorption on the back surface and improve the bifaciality, while lowering process difficulty, ensuring the passivation effect, and controlling costs.

Specifically, in such embodiments, the thickness of the portion of the second transparent conductive film 50 corresponding to the textured region 122 may be, for example, one of the following values: 75 nm, 76 nm, 77 nm, 78 nm, 79 nm, 80 nm, 81 nm, 82 nm, 83 nm, 84 nm, or 85 nm, with no specific limitations imposed herein.

In some embodiments, the thickness of the first transparent conductive film 40 may range from 90 nm to 155 nm.

Accordingly, setting the thickness of the first transparent conductive film 40 within the reasonable range can avoid excessive manufacturing difficulty due to an overly small thickness of the portion of the first transparent conductive film 40 corresponding to the polished region 121, as well as a poor passivation effect on the first polar doped layer 22 caused by the overly small thickness. Additionally, excessive cost increases due to an overly large thickness can also be avoided.

Specifically, in this embodiment, the thickness of the portion of the first transparent conductive film 40 corresponding to the polished region 121 may be, for example, one of the following values: 90 nm, 95 nm, 100 nm, 105 nm, 110 nm, 115 nm, 120 nm, 125 nm, 130 nm, 135 nm, 140 nm, 145 nm, 150 nm, or 155 nm, with no specific limitations imposed herein.

In some embodiments, a ratio of the thickness of the first transparent conductive film 40 to the thickness of the portion of the second transparent conductive film 50 corresponding to the textured region 122 ranges from 1.2 to 1.8.

Accordingly, by setting the ratio of the thickness of the first transparent conductive film 40 to the thickness of the portion of the second transparent conductive film 50 corresponding to the textured region 122 within the reasonable range, an optimal matching effect between the parasitic absorption and the passivation effect on the back surface 12 can be achieved.

Specifically, in such embodiments, the ratio between the two may be, for example, one of the following values: 1.2, 1.25, 1.3, 1.35, 1.4, 1.45, 1.5, 1.55, 1.6, 1.65, 1.7, 1.75, or 1.8, with no specific limitations imposed herein.

Referring to Fig. 3, in some embodiments, the first polar doped layer 22 and the second polar doped layer 32 are adjacent in the first direction. That is, the polished region 121 and the textured region 122 are continuous and adjacent in the first direction, with the first polar doped layer 22 and the second polar doped layer 32 in contact.

Accordingly, an area on the back surface 12 of the silicon substrate 10 that is not covered by the first polar doped layer 22 and the second polar doped layer 32 (i.e., an area of an undoped region) can be reduced as much as possible, thereby improving the efficiency of the back contact cell 100.

Specifically, in such embodiments, the first polar doped layer 22 may be a doped polysilicon layer, while the second polar doped layer 32 may be at least one of a doped amorphous silicon layer or a doped microcrystalline silicon layer. Since the transverse conductivity of the doped amorphous silicon layer and the doped microcrystalline silicon layer is poor, the first polar doped layer 22 and the second polar doped layer 32 may be arranged adjacent to each other to improve efficiency.

Certainly, as shown in Fig. 4, in other embodiments, the first polar doped layer 22 and the second polar doped layer 32 may also be spaced apart in the first direction, with a gap region or another dielectric film layer separating them, with no specific limitations imposed herein.

Further, referring to Fig. 3 and Fig. 4, in some embodiments, the first transparent conductive film 40 may be stacked solely on the first polar doped layer 22, the second passivation layer 31 and the second polar doped layer 32 may be stacked solely on the textured region 122, and the second transparent conductive film 50 may be stacked solely on the second polar doped layer 32.

Accordingly, the insulation performance between the first transparent conductive film 40 and the second transparent conductive film 50 can be improved, thereby preventing electrical leakage.

Specifically, in such embodiments, as shown in Fig. 3, when the first polar doped layer 22 and the second polar doped layer 32 are adjacent, the first transparent conductive film 40 may cover the vast majority of the region of the first polar doped layer 22, while the second transparent conductive film 50 may fully cover the second polar doped layer 32 or cover the vast majority of the region of the second polar doped layer 32. In this case, a spacing between the two transparent conductive films may be controlled by controlling an area of regions covered by the two transparent conductive films, thereby ensuring their insulation performance.

As shown in Fig. 4, when the first polar doped layer 22 and the second polar doped layer 32 are spaced apart, the first transparent conductive film 40 may fully cover the first polar doped layer 22 or cover the vast majority of the region of the first polar doped layer 22, while the second transparent conductive film 50 may fully cover the second polar doped layer 32 or cover the vast majority of the region of the second polar doped layer 32. In this case, the spacing between the two transparent conductive films may be controlled by controlling an area of covered regions of the first polar doped layer 22 and the second polar doped layer 32 which are adjacent, thereby ensuring their insulation performance.

In some embodiments, the first polar doped layer 22 may be a base doped layer, while the second polar doped layer 32 may be an emitter doped layer. A total orthographic projection area of all the second polar doped layers 32 on the silicon substrate 10 is greater than that of all the first polar doped layers 22 on the silicon substrate 10.

Accordingly, an emitter area in the back contact cell 100 can be increased, thereby improving back contact efficiency.

Specifically, in such embodiments, when the silicon substrate 10 is an N-type silicon substrate 10, the first polar doped layer 22 is an N-type doped layer, and the second polar doped layer 32 is a P-type doped layer. When the silicon substrate 10 is a P-type silicon substrate 10, the first polar doped layer 22 is a P-type doped layer, and the second polar doped layer 32 is an N-type doped layer.

Further, in such embodiments, a ratio of the total orthographic projection area of all the second polar doped layers 32 on the silicon substrate 10 to an area of the back surface 12 ranges from 65% to 85%, while a ratio of the total orthographic projection area of all the first polar doped layers 22 on the silicon substrate 10 to the area of the back surface 12 ranges from 15% to 35%.

Accordingly, by setting the area ratios of the first polar doped layer 22 and the second polar doped layer 32 within the foregoing reasonable ranges, an area of an emitter region can be increased while maintaining an area ratio of a base region, thereby further optimizing the efficiency of the back contact cell 100.

Specifically, in such embodiments, the ratio of the total orthographic projection area of all the second polar doped layers 32 on the silicon substrate 10 to the area of the back surface 12 may be, for example, one of the following values: 65%, 70%, 75%, 80%, or 85%, with no specific limitations imposed herein. The ratio of the total orthographic projection area of all the first polar doped layers 22 on the silicon substrate 10 to the area of the back surface 12 may be, for example, one of the following values: 15%, 20%, 25%, 30%, or 35%, with no specific limitations imposed herein.

It should be understood that, in such embodiments, when the first polar doped layer 22 fully covers the polished region 121 and the second polar doped layer 32 fully covers the textured region 122, the total area of all the textured regions 122 is greater than the total area of all the polished regions 121. In this case, a ratio of the total area of all the textured regions 122 to the area of the back surface 12 ranges from 65% to 85%, and a ratio of the total area of all the polished regions 121 to the area of the back surface 12 ranges from 15% to 35%.

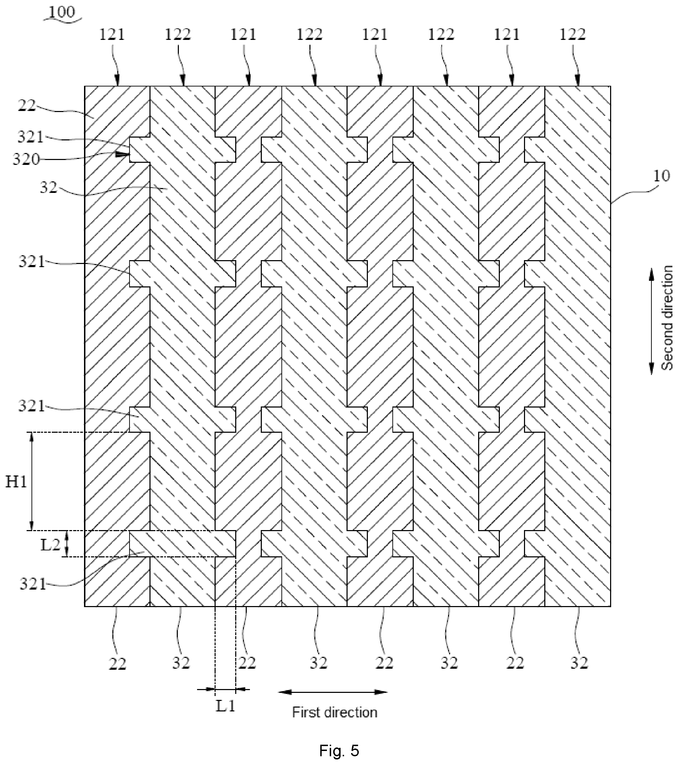

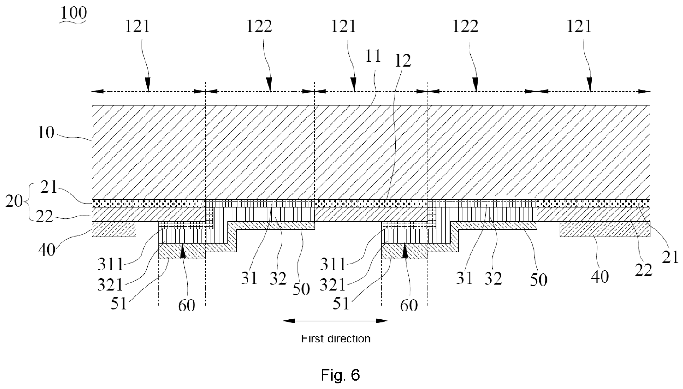

Referring to Fig. 5 and Fig. 6, in some embodiments, at preset positions 320 of at least some of the second passivation contact structures 30, the second passivation layer 31 has a passivation extension 311 that extends to cover part of the region of the first polar doped layer 22. The second polar doped layer 32 has a doping extension 321 that extends to cover the passivation extension 311, thereby forming a stacked structure 60 on a portion of the polished region 121, where the first passivation layer 21, the first polar doped layer 22, the passivation extension 311, and the doping extension 321 are sequentially stacked.

The second transparent conductive film 50 has a film extension 51 that extends onto at least a part of a region of the doping extension 321, while the first transparent conductive film 40 is stacked at least on a region of the first polar doped layer 22 not covered by the passivation extension 311 and the doping extension 321.

Accordingly, through the stacked structure 60 and the extended configuration of the second transparent conductive film 50, the back contact cell 100 can form an electric leakage channel at the position of the stacked structure 60, thereby creating electric leakage points in the thickness direction, reducing a reverse breakdown voltage when the back contact cell 100 is shaded, enhancing hot spot resistance of the back contact cell 100, and lowering a hot spot risk of the cell assembly 200.

Specifically, the doping extension 321 forms an electric leakage contact with the first polar doped layer 22 at the stacked structure 60, and the stacked structure 60 is an electric leakage contact structure. On the doping extension 321, a region covered by the film extension 51 is an effective electric leakage area, while a region not covered by the second transparent conductive film 50 is an ineffective electric leakage area. In the back contact cell 100, only the effective electric leakage area can function as improving hot spot resistance.

In such embodiments, the first polar doped layer 22 is a doped polysilicon layer, preferably an N-type doped polysilicon layer, while the second polar doped layer 32 is at least one of a doped amorphous silicon layer or a doped microcrystalline silicon layer, preferably at least one of a P-type doped amorphous silicon layer or a P-type doped microcrystalline silicon layer.

Further, as shown in Fig. 5, in this embodiment of the present disclosure, in the back contact cell 100, all the second polar doped layers 32 may have preset positions 320, meaning that all the second polar doped layers may have doping extensions 321 that extend onto the first polar doped layer 22 at the preset positions 320. Alternatively, only some of the second polar doped layers 32 may have doping extensions 321 that extend onto the first polar doped layer 22 at the preset positions 320. No specific limitations are imposed herein, as long as an electric leakage contact area formed between the doping extensions 321 and the first polar doped layer 22 does not significantly reduce the efficiency of the back contact cell 100.

Additionally, for a single second polar doped layer 32, the single second polar doped layer 32 may have a plurality of doping extensions 321, thereby forming a plurality of stacked structures 60 on a single polished region 121. When the single second polar doped layer 32 has the plurality of doping extensions 321, the plurality of doping extensions 321 may be spaced apart in the second direction, with no specific limitations imposed herein.

Additionally, in some embodiments, for a single second polar doped layer 32, the single second polar doped layer 32 may have doping extensions 321 formed on only one side or on two sides, with no specific limitations imposed herein. Fig. 5 shows a second polar doped layer 32 having doping extensions 321 on two sides, while Fig. 6 shows a second polar doped layer 32 having doping extensions 321 on only one side. However, no limitations are imposed in the present disclosure regarding this aspect.

In some embodiments, a thickness of the film extension 51 is greater than the thickness of the portion of the second transparent conductive film 50 corresponding to the textured region 122. Preferably, the thickness of the film extension 51 may be the same as that of the first transparent conductive film 40.

Accordingly, increasing the thickness of the first transparent conductive film 40 on the first polar doped layer 22 and the film extension 51 may enhance the passivation effect in the corresponding region of the first polar doped layer 22. Meanwhile, reducing the thickness of the portion of the second transparent conductive film 50 corresponding to the textured region 122 may reduce the parasitic absorption while achieving efficient passivation in the region corresponding to the doped amorphous silicon or the doped polysilicon, thereby improving the bifaciality.

Referring to Fig. 3, in some embodiments, a length L1 of the doping extension 321 in the first direction may range from 10 µm to 600 µm, while a length L2 of the doping extension 321 in the second direction may range from 10 µm to 5000 µm.

Accordingly, by reasonably setting the lengths of the doping extension 321 in various directions, an area of the doping extension 321 may be controlled within a reasonable range, thereby controlling an effective electric leakage contact area of a single doping extension 321 within a reasonable range, preventing the hot spot resistance from falling short of an expected effect due to an excessively small electric leakage contact area and avoiding significant efficiency loss due to an excessively large electric leakage contact area. In other words, this arrangement may balance a relationship between hot spot resistance and efficiency, achieving an optimal matching effect.

Specifically, in such embodiments, the length L1 of the doping extension 321 in the first direction may be, for example, one of the following: 10 µm, 20 µm, 30 µm, 40 µm, 50 µm, 60 µm, 70 µm, 80 µm, 90 µm, 100 µm, 150 µm, 200 µm, 250 µm, 300 µm, 350 µm, 400 µm, 450 µm, 500 µm, 550 µm, or 600 µm.

The length L2 of the doping extension 321 in the second direction may be, for example, one of the following: 10 µm, 20 µm, 30 µm, 40 µm, 50 µm, 60 µm, 70 µm, 80 µm, 90 µm, 100 µm, 150 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, 1000 µm, 1500 µm, 2000 µm, 2500 µm, 3000 µm, 3500 µm, 4000 µm, 4500 µm, or 5000 µm.

Further, in such embodiments, the length L1 of the doping extension 321 in the first direction is preferably 10 µm to 150 µm, while the length L2 of the doping extension 321 in the second direction is preferably 20 µm to 500 µm.

In some embodiments, the length of the film extension 51 in the first direction is greater than or equal to 10 µm.

Accordingly, the poor hot spot resistance effect caused by an excessively small extension length of the film extension 51 can be avoided.

Moreover, in such embodiments, a ratio of the length of the film extension 51 in the first direction to a length of the doping extension 321 in the first direction is greater than 90%, such as any one of the following: 91%, 92%, 93%, 94%, 95%, 96%, 97%, 98%, and 99%.

Accordingly, by setting the ratio of the length of the film extension 51 to the length of the doping extension 321 within an optimal range of greater than 90%, the hot spot resistance can be effectively improved while the conversion efficiency can be ensured.

Specifically, as mentioned above, in some embodiments, the length of the doping extension 321 in the first direction ranges from 10 µm to 600 µm, preferably 10 µm to 150 µm. In this embodiment, a minimum length of a portion of the second transparent conductive film 50 extending onto the doping extension 321 in the first direction is greater than 9 µm, while a maximum length may be greater than 540 µm and less than or equal to 600 µm, preferably greater than 135 µm and less than 150 µm.

Referring to Fig. 5, in some embodiments, a single second polar doped layer 32 may have a plurality of doping extensions 321 arranged at intervals in the second direction. That is, in the second direction, the plurality of spaced doping extensions 321 are arranged on one side of the second polar doped layer 32.

Accordingly, by arranging the plurality of isolated doping extensions 321 on the second polar doped layer 32, an excessive electric leakage contact area on a single second polar doped layer 32, which may lead to significant efficiency loss, can be avoided.

It should be understood that in some embodiments, when the second polar doped layer 32 forms an electric leakage contact with two adjacent first polar doped layers 22, doping extensions 321 are formed on two sides of the second polar doped layer 32 in the first direction. When the second polar doped layer 32 forms the electric leakage contact with only one first polar doped layer 22, doping extensions 321 are formed on only one side of the second polar doped layer 32 in the first direction.

Further, as shown in Fig. 5, in some embodiments, a distance H1 between two adjacent doping extensions 321 in the second direction ranges from 1 cm to 10 cm.

This prevents the distance H1 between the two adjacent doping extensions 321 from being too small, which may cause excessive concentration of leakage points, leading to a significant temperature rise due to untimely heat dissipation.

Specifically, in such embodiments, the distance H1 between the two adjacent doping extensions 321 may be, for example, one of the following: 1 cm, 1.5 cm, 2 cm, 2.5 cm, 3 cm, 3.5 cm, 4 cm, 4.5 cm, 5 cm, 5.5 cm, 6 cm, 6.5 cm, 7 cm, 7.5 cm, 8 cm, 8.5 cm, 9 cm, 9.5 cm, or 10 cm.

Further, in such embodiments, the distance H1 between the two adjacent doping extensions 321 in the second direction is preferably greater than or equal to 2 cm and less than 4 cm.

Accordingly, through research and demonstration by the inventors of the present disclosure, setting the distance within the preferred range can prevent excessive heat concentration to the greatest extent in a case of setting a large number of doping extensions 321. In other words, the arrangement may balance a relationship between hot spot resistance and excessive heat concentration, achieving an optimal matching effect.

Specifically, in such embodiments, the distance H1 between the two adjacent doping extensions 321 may preferably be, for example, one of the following: 2 cm, 2.2 cm, 2.4 cm, 2.6 cm, 2.8 cm, 3 cm, 3.1 cm, 3.2 cm, 3.3 cm, 3.4 cm, 3.5 cm, 3.6 cm, 3.7 cm, 3.9 cm, or 3.95 cm.

In some embodiments, in the back contact cell 100, a distribution density of the doping extensions 321 ranges from 0.01 per cm² to 1.5 per cm². Accordingly, by reasonably controlling the distribution density of the doping extensions 321, excessive concentrated distribution of the electric leakage points can be avoided.

In such embodiments, the distribution density of the doping extensions 321 refers to a ratio of the total number of the doping extensions 321 on the back contact cell 100 to the area of the back surface 12 of the back contact cell 100. Specifically, the distribution density of the doping extensions 321 may be, for example, one of the following: 0.01 per cm², 0.05 per cm², 0.1 per cm², 0.2 per cm², 0.3 per cm², 0.4 per cm², 0.5 per cm², 0.6 per cm², 0.7 per cm², 0.8 per cm², 0.9 per cm², 1 per cm², 1.1 per cm², 1.2 per cm², 1.3 per cm², 1.4 per cm², or 1.5 per cm².

In some embodiments, in a single doping extension 321, an area of the film extension 51 ranges from 100 µm² to 50000 µm².

Accordingly, by controlling the area of the film extension 51 within the reasonable range, it is ensured the efficiency loss is not significant while the hot spot resistance can be improved.

Specifically, in such embodiments, the area of a single film extension 51 may be, for example, one of the following: 100 µm², 200 µm², 300 µm², 350 µm², 400 µm², 450 µm², 480 µm², 500 µm², 600 µm², 700 µm², 800 µm², 900 µm², 1000 µm², 1100 µm², 1200 µm², 1300 µm², 1400 µm², 1500 µm², 2000 µm², 3000 µm², 4000 µm², 5000 µm², 6000 µm², 7000 µm², 8000 µm², 9000 µm², 10000 µm², 15000 µm², 20000 µm², 25000 µm², 30000 µm², 35000 µm², 40000 µm², 45000 µm², or 50000 µm².

In some embodiments, in the back contact cell 100, a ratio of the total area of all the film extensions 51 (i.e., the sum of the effective electric leakage areas of the doping extensions 321 in the back contact cell 100) to the area of the back surface 12 ranges from 1.5*10⁻⁸ to 1.5*10⁻⁵.

Accordingly, setting the ratio of the total area of all the film extensions 51 to the area of the back surface 12 within the reasonable range can avoid a significant impact on the efficiency of the back contact cell 100 caused by an overly large proportion of the electric leakage contact area, that is, both the hot spot resistance and the efficiency of the back contact cell 100 can be ensured.

Specifically, in such embodiments, the area ratio between the two may be, for example, one of the following: 1.5*10⁻⁸, 2*10⁻⁸, 2.5*10⁻⁸, 3.5*10⁻⁸, 4.5*10⁻⁸, 4.5*10⁻⁸, 5*10⁻⁸, 6*10⁻⁸, 7*10⁻⁸, 8*10⁻⁸, 9*10⁻⁸, 1*10⁻⁷, 1*10⁻⁶, 1*10⁻⁵, and 1.5*10⁻⁵, with no specific limitations imposed herein. In some embodiments, the ratio between the two is preferably greater than 1.5*10⁻⁸ and less than 4.5*10⁻⁸.

In the descriptions of this specification, descriptions using reference terms such as "some embodiments", "an exemplary embodiment", "an example", "a specific example", or "some examples" mean that specific features, structures, materials, or characteristics described with reference to the embodiment or the example are included in at least one embodiment or example of the present disclosure. In the specification, the schematic representations of the foregoing terms are not necessarily intended to refer to the same embodiment or example. Moreover, the described specific features, structures, materials, or characteristics may be combined in a suitable manner in any one or more of the embodiments or examples.

Additionally, the foregoing descriptions are merely preferred embodiments of the present disclosure, but are not intended to limit the present disclosure. Any modification, equivalent substitution, improvement, etc. made within the spirit and principle of the present disclosure shall fall within the scope of protection of the present disclosure.

## Claims

1. A back contact cell, comprising:
a silicon substrate, having a front surface and a back surface which are opposite, wherein the back surface comprises a plurality of polished regions and a plurality of textured regions which are alternately arranged in a first direction and all extend in a second direction, and the second direction intersects with the first direction;
first passivation contact structures, wherein each of the first passivation contact structures comprises a first passivation layer and a first polar doped layer sequentially stacked on the polished region;
second passivation contact structures, wherein each of the second passivation contact structures comprises a second passivation layer and a second polar doped layer sequentially stacked on the textured region, wherein the second passivation layer and the second polar doped layer cover at least the textured region; and
first transparent conductive films and second transparent conductive films, wherein the first transparent conductive films are stacked on the first polar doped layer and covers at least part of a region of the first polar doped layer, while the second transparent conductive films are stacked on the second polar doped layer and covers at least part of a region of a portion of the second polar doped layer corresponding to the textured region, the second transparent conductive films are insulated and spaced apart from the first transparent conductive films, and a thickness of the portion of the second transparent conductive films corresponding to the textured region is less than a thickness of the first transparent conductive films.

2. The back contact cell according to claim 1, wherein the first passivation layer is a tunneling oxide layer, and the first polar doped layer is a doped polysilicon layer; and
the second passivation layer is at least one of an intrinsic amorphous silicon layer or a tunneling oxide layer, while the second polar doped layer is at least one of a doped amorphous silicon layer or a doped microcrystalline silicon layer.

3. The back contact cell according to claim 1, wherein the thickness of the portion of the second transparent conductive film corresponding to the textured region ranges from 75 nm to 85 nm.

4. The back contact cell according to claim 1, wherein a thickness of the first transparent conductive film ranges from 90 nm to 155 nm.

5. The back contact cell according to claim 1, wherein a ratio of the thickness of the first transparent conductive film to the thickness of the portion of the second transparent conductive film corresponding to the textured region ranges from 1.2 to 1.8.

6. The back contact cell according to claim 1, wherein the first polar doped layer and the second polar doped layer are adjacent in the first direction; or
the first polar doped layer and the second polar doped layer are spaced apart in the first direction.

7. The back contact cell according to claim 6, wherein the first transparent conductive film is stacked solely on the first polar doped layer, the second passivation layer and the second polar doped layer are stacked solely on the textured region, and the second transparent conductive film is stacked solely on the second polar doped layer.

8. The back contact cell according to claim 1, wherein the first polar doped layer is a base doped layer, while the second polar doped layer is an emitter doped layer, and a total orthographic projection area of all the second polar doped layers on the silicon substrate is greater than that of all the first polar doped layers on the silicon substrate.

9. The back contact cell according to claim 8, wherein a ratio of the total orthographic projection area of all the second polar doped layers on the silicon substrate to an area of the back surface ranges from 65% to 85%

10. The back contact cell according to claim 1, wherein at preset positions of at least some of the second passivation contact structures, the second passivation layer has a passivation extension that extends to cover part of the region of the first polar doped layer, and the second polar doped layer has a doping extension that extends to cover the passivation extension, to form a stacked structure on a portion of the polished region, where the first passivation layer, the first polar doped layer, the passivation extension, and the doping extension are sequentially stacked; and
the second transparent conductive film has a film extension that extends onto at least a part of a region of the doping extension, while the first transparent conductive film is stacked at least on a region of the first polar doped layer not covered by the passivation extension and the doping extension.

11. The back contact cell according to claim 10, wherein a thickness of the film extension is greater than the thickness of the portion of the second transparent conductive film corresponding to the textured region.

12. The back contact cell according to claim 10, wherein the thickness of the film extension is the same as that of the first transparent conductive film.

13. A cell assembly, comprising a plurality of back contact cells according to any one of claims 1 to 12.

14. A photovoltaic system, comprising the cell assembly according to claim 13.
